# EUROPEAN PATENT APPLICATION

(11) **EP 3 666 933 A1**
(43) Date of publication of application: **17.06.2020**
(21) Application number: 18922089.0
(22) Date of filing: 26.12.2018
(51) Int. Cl.: C30B 23/00, C30B 29/36

(54) **LARGE-SIZE HIGH-PURITY SILICON CARBIDE SINGLE CRYSTAL, SUBSTRATE, PREPARATION METHOD THEREFOR AND PREPARATION DEVICE THEREOF**

(30) Priority: 16.10.2018 CN 201811204726; 16.10.2018 CN 201811204668; 16.10.2018 CN 201821676275 U
(71) Applicant: SICC Co., Ltd, Shandong 250118 (CN)
(72) Inventor: The designation of the inventor has not yet been filed
(74) Representative: Bergenstråhle Group AB
(86) International application number: PCT/CN2018/123708
(87) International publication number: WO 2020/077847

(57) **Abstract**

The present application discloses a large-sized high-purity silicon carbide single crystal, a substrate and a preparation method thereof, and a preparation device thereof, and belongs to the field of silicon carbide single crystals and substrates thereof. In the present application, by changing a thermal field distribution of a PVT method, and changing the conventional method for creating an axial temperature gradient through heat dissipation with an upper thermal insulation hole, into creating the axial temperature gradient by using different wall thicknesses of the crucible and different thicknesses of the thermal insulation structure, and changing a thermal insulation structure on the upper side of the graphite crucible at a same time, a thermal field structure with a uniform radial temperature distribution is created; especially, the radial distribution of the internal thermal field of the large-sized crucible is uniform; since the electroactive impurity element grows into the crystal along with the temperature gradient, such a thermal field structure with a uniform radial temperature distribution will direct the electroactive impurity element to be uniformly distributed in the radial direction, to further prepare the high-purity semi-insulating silicon carbide single crystal and the single crystal substrate having a uniform radial resistivity and a low stress.

## Description

### TECHNICAL FIELD

The present application relates to a large-sized high-purity silicon carbide single crystal, a single crystal substrate and a preparation method thereof, and a preparation device thereof, and belongs to the field of silicon carbide single crystals and substrates thereof.

### BACKGROUND

With nearly 30 years of development since commercialization in the 1990s, a semiconductor silicon carbide single crystal material has gradually become a preferred substrate material for power electronic devices and microwave radio frequency devices. With continuous development of a downstream device technology and constantly increasing degree of industrialization, quality requirements of silicon carbide single crystal substrates are becoming increasingly stringent.

At present, the most mature silicon carbide single crystal preparation technology is a physical vapor transport (PVT) method, whose basic principle is that a graphite crucible placed in a center of a coil is heated by medium-frequency induction, the graphite crucible wall generates heat by induction and transmits heat to a silicon carbide powder therein to sublimate the same. A perforating circular hole is provided at a center of graphite thermal insulation felt on an upper side of the graphite crucible, and through the circular hole, heat is dissipated while a temperature is measured, creating an axial temperature gradient with a high temperature at a lower portion of the crucible and a low temperature at an upper portion thereof, to drive a sublimated vapor to be transported from a powder region in a growth chamber to a seed crystal region of a top portion of the crucible for crystallization. The silicon carbide single crystals prepared by using the method have evolved from 2 inches to 8 inches and are constantly applied to downstream devices.

However, as a crystal size continuously increases, a diameter of the crucible also increases. Since the crucible wall is used as a heat source in the heating mode of medium-frequency induction, a radial temperature gradient along a direction from the crucible wall to the crucible center also increases; in addition, in the PVT method, the axial temperature gradient is created by taking the thermal insulation center circular hole on the upper side of the crucible as a heat dissipation center, which further causes radial non-uniformity of a thermal field inside the crucible, resulting in problems such as relatively large thermal stress in a radial direction of the crystal, and uneven distribution of impurities and defects. The thermal stress existing in the former easily leads to serious quality problems such as cracking during crystal processing, and unqualified Bow and Warp during substrate processing; and the uneven distribution of impurities and defects in the latter will seriously restrict resistivity uniformity of the substrate along the radial direction.

### SUMMARY

In order to solve the above-described problems, one aspect of the present application provides a device for growing a silicon carbide single crystal, which, by redesigning a crucible and a thermal insulation structure coated on a periphery of the graphite crucible, has a uniform thermal field formed in a radial direction, so as to improve radial uniformity of the silicon carbide single crystal, and make it possible to prepare a high-quality large-sized high-purity semi-insulating silicon carbide single crystal substrate.

The device for growing the silicon carbide single crystal comprises a graphite crucible, a heating unit, a seed crystal unit and a thermal insulation structure, wherein, the thermal insulation structure includes a thermal insulation structure top portion, a thermal insulation structure side portion and a thermal insulation structure bottom portion; an inner wall of the graphite crucible has a substantially cylindrical shape, a side wall of the graphite crucible is linearly thickened along a direction from a bottom to an opening of the graphite crucible.

Optionally, the seed crystal unit is provided in an upper position of the opening of the graphite crucible, the thermal insulation structure does not have an opening structure, and the seed crystal unit includes a seed crystal of the silicon carbide single crystal.

Optionally, the graphite crucible is located in a sealed cavity of the thermal insulation structure.

Optionally, a wall portion of the thermal insulation structure side portion is linearly thickened along a direction from the opening to the bottom of the graphite crucible.

Optionally, there is a first distance from an opening cross section of the graphite crucible to an inner surface of the thermal insulation structure top portion above it, and the first distance increases along a direction from a center of the graphite crucible to an edge of the graphite crucible.

Optionally, the heating unit heats the graphite crucible by induction. Preferably, the heating unit includes a medium-frequency coil.

Optionally, the graphite crucible and the thermal insulation structure share a first central axis;

The first central axis is parallel to an inner surface of the side wall of the graphite crucible and/or an outer surface of the thermal insulation structure side portion;

The first central axis has a first angle with an outer surface of the side wall of the graphite crucible, the first central axis has a second angle with an inner surface of the thermal insulation structure side portion; and values of the first angle and the second angle are 5° to 30°. Further, the values of the first angle and the second angle have lower limits selected from 7°, 10°, 13° or 15°, and upper limits selected from 28°, 25°, 23°, 20° or 18°.

Optionally, the values of the first angle and the second angle are 10° to 25°.

Optionally, the first angle and the second angle are substantially equal.

Optionally, there may be a first distance from an opening cross section of the graphite crucible to the inner surface of the thermal insulation structure top portion above it, and the first distance increases along a direction from a center of the graphite crucible to an edge of the graphite crucible. As an implementation mode, the thermal insulation structure top portion has a dome shape.

Optionally, a range of a change value of the first distance is 5 mm to 50 mm. Optionally, the range of the change value of the first distance has a lower limit selected from 10 mm, 15 mm, 20 mm, 25 mm or 30 mm, and an upper limit selected from 15 mm, 20 mm, 25 mm, 30 mm, 35 mm, 40 mm or 45 mm.

Optionally, the range of the change value of the first distance is 10 mm to 45 mm.

Optionally, an outer surface of the thermal insulation structure is a cylinder, the thermal insulation structure top portion has no opening; an inner surface of the thermal insulation structure bottom portion is substantially cylindrical; along the direction from the bottom to the opening of the graphite crucible, the inner surface of the thermal insulation structure side portion extends in a direction away from the central axis of the graphite crucible; and the thermal insulation structure top portion is thickened along the direction from the edge to the center of the graphite crucible.

Optionally, the inner surface of the side wall of the graphite crucible is substantially cylindrical, and an outer wall of the graphite crucible has substantially a same extension direction as the inner surface of the thermal insulation structure side portion.

According to another aspect of the present application, there is provided a crystal growing device, comprising the device according to any one of the above.

Preferably, the crystal growing device is used in preparation of a semi-insulating silicon carbide single crystal having a diameter of 4 to 12 inches and a substrate thereof. Further, the crystal growing device is used in preparation of a semi-insulating silicon carbide single crystal having a diameter greater than 8 inches and less than or equal to 12 inches and a substrate thereof.

According to still another aspect of the present application, the present application provides a thermal field structure for growing a silicon carbide single crystal; and the thermal field structure, by redesigning a crucible and a thermal insulation structure coated on the periphery of the crucible, has a uniform thermal field structure formed in a radial direction, so as to improve radial uniformity of the silicon carbide single crystal, and make it possible to prepare a high-quality large-sized high-purity semi-insulating silicon carbide single crystal substrate.

The thermal field structure for growing the silicon carbide single crystal comprises a crucible, a heating unit and a thermal insulation structure, wherein, the thermal insulation structure includes a thermal insulation structure top portion, a thermal insulation structure side portion and a thermal insulation structure bottom portion; and the crucible is located in a sealed cavity of the thermal insulation structure;

The side wall of the crucible has a wall thickness of an opening region greater than a wall thickness of a bottom region.

Optionally, the crucible and the thermal insulation structure are such that the crucible has an axial temperature gradient therein, and/or a radial temperature gradient is close to zero.

Preferably, the crucible is a graphite crucible.

Optionally, the side wall of the crucible is linearly thickened along a direction from a bottom to an opening of the crucible.

Preferably, the wall portion of the thermal insulation structure side portion is linearly thickened along a direction from the opening to the bottom of the crucible.

Optionally, there is a first distance from an opening cross section of the crucible to an inner surface of the thermal insulation structure top portion above it, and the first distance increases along a direction from a center of the crucible to an edge of the crucible.

Preferably, a range of a change value of the first distance is 5 mm to 50 mm. Optionally, the range of the change value of the first distance has a lower limit selected from 10 mm, 15 mm, 20 mm, 25 mm or 30 mm, and an upper limit selected from 15 mm, 20 mm, 25 mm, 30 mm, 35 mm, 40 mm or 45 mm.

Optionally, the crucible and the thermal insulation structure substantially share a first central axis;

The first central axis is substantially parallel to an inner surface of the side wall of the crucible and/or an outer surface of the thermal insulation structure side portion;

The first central axis has a first angle with an outer surface of the side wall of the crucible, the first central axis has a second angle with an inner surface of the thermal insulation structure side portion, and the first angle and the second angle are < 90°.

Further, the crucible and the thermal insulation structure share the first central axis;

The first central axis is parallel to the inner surface of the side wall of the crucible and/or the outer surface of the thermal insulation structure side portion;

The first central axis has a first angle with the outer surface of the side wall of the crucible, the first central axis has a second angle with the inner surface of the thermal insulation structure side portion, and the first angle and the second angle are < 90°.

Optionally, a value of the first angle is 5° to 30°, and a value of the second angle is 5° to 30°. Further, the values of the first angle and the second angle have lower limits selected from 7°, 10°, 13° or 15°, and upper limits selected from 28°, 25°, 23°, 20° or 18°.

Optionally, the first angle and the second angle are substantially equal.

Optionally, an outer surface of the thermal insulation structure is a cylinder, the thermal insulation structure top portion has no opening; an inner surface of the thermal insulation structure bottom portion is substantially cylindrical; along the direction from the bottom to the opening of the crucible, the inner surface of the thermal insulation structure side portion extends in a direction away from the center of the crucible; and the thermal insulation structure top portion is thickened in the direction from the edge to the center of the crucible;

The inner surface of the side wall of the crucible is substantially cylindrical, and an outer wall of the crucible has substantially a same extension direction as the inner surface of the thermal insulation structure side portion.

Optionally, the thermal field structure further includes a seed crystal unit, the seed crystal unit is provided in an upper position of the opening of the crucible, and the thermal insulation structure does not have an opening structure. The seed crystal unit includes a seed crystal of the silicon carbide single crystal.

According to still another aspect of the present application, there is provided a preparation method of a silicon carbide single crystal, which is prepared with the thermal field structure according to any one of the above.

According to yet another aspect of the present application, there is provided a crystal growing device, comprising the thermal field structure according to any one of the above.

Preferably, the crystal growing device is used for preparing a semi-insulating silicon carbide single crystal having a diameter of 4 to 12 inches and a substrate thereof. Further, the crystal growing device is used for preparing a semi-insulating silicon carbide single crystal having a diameter greater than 8 inches and less than or equal to 12 inches and a substrate thereof.

According to a further aspect of the present application, there is provided a preparation method of a silicon carbide single crystal, which, by redesigning a crucible and a thermal insulation structure coated on the periphery of the crucible, has a uniform thermal field structure formed in a radial direction, so as to improve radial uniformity of the silicon carbide single crystal, and make it possible to prepare a high-quality large-sized high-purity semi-insulating silicon carbide single crystal substrate.

The preparation method of the large-sized high-purity silicon carbide single crystal comprises steps of:
1) Assembly stage: installing a seed crystal unit in the crucible filled with a silicon carbide powder, placing the crucible in a cavity of a sealed thermal insulation structure, and transferring the whole system into a crystal growing device;
2) Impurity removal stage: sealing the crystal growing device and evacuating the same, removing impurities and then charging a shielding gas;
3) Crystal growth stage: controlling, by a heating unit of the crystal growing device, a temperature of the crucible for crystal growth, to obtain the high-purity silicon carbide single crystal.

Optionally, purity of the silicon carbide powder is not lower than 99.9999%, wherein, a concentration of shallow-energy-level donor impurities in the silicon carbide powder is not higher than 1×10¹⁶ cm⁻³, and a concentration of shallow-energy-level acceptor impurities is not higher than 1×10¹⁶ cm⁻³.

Further, the concentration of the shallow-energy-level donor impurities is not higher than 1×10¹⁵ cm⁻³, and the concentration of the shallow-energy-level acceptor impurities is not higher than 1×10¹⁵ cm⁻³.

Optionally, the shallow-energy-level donor impurities include a nitrogen element, and the shallow-energy-level acceptor impurities include boron and aluminum.

Optionally, the crystal growth stage includes: raising a pressure inside the crucible to 10 mbar to 100 mbar at a rate of 30 mbar/h to 50 mbar/h while increasing a temperature inside the crucible to 2,100°C to 2,200°C at a rate of 10°C/h to 20°C/h, and holding for 50 h to 100 h.

Further, the crystal growth stage includes: raising the pressure inside the crucible to 20 mbar to 80 mbar at a rate of 35 mbar/h to 45 mbar/h while increasing the temperature inside the crucible to 2,100°C to 2,200°C at a rate of 10°C/h to 20°C/h, and holding for 60 h to 80 h.

Optionally, the impurity removal stage includes: evacuating the crucible so that a pressure therein is 10⁻⁵ Pa and holding for 5 h to 10 h, and then charging shielding gases. Further, the crucible is evacuated so that the pressure therein is 10⁻⁵ Pa, and holding for 6 h to 9 h. Further, the shielding gases are argon and helium.

Optionally, the crucible and the thermal insulation structure are such that the crucible has an axial temperature gradient therein, and/or a radial temperature is uniform. Preferably, the crucible and the thermal insulation structure are such that the crucible has a radial temperature gradient therein close to zero.

Preferably, the crucible is a graphite crucible.

Optionally, a side wall of the crucible is linearly thickened along a direction from a bottom to an opening of the crucible.

Preferably, the thermal insulation structure includes a thermal insulation structure top portion, a thermal insulation structure side portion and a thermal insulation structure bottom portion; and a wall portion of the thermal insulation structure side portion is linearly thickened along a direction from the opening to the bottom of the crucible.

Optionally, the crucible and the thermal insulation structure substantially share a first central axis;

The first central axis is substantially parallel to an inner surface of the side wall of the crucible and/or an outer surface of the thermal insulation structure side portion;

The first central axis has a first angle with an outer surface of the side wall of the crucible, and/or the first central axis has a second angle with an inner surface of the thermal insulation structure side portion, the first angle is < 90°, and the second angle is < 90°.

Further, the crucible and the thermal insulation structure share the first central axis;

The first central axis is parallel to the inner surface of the side wall of the crucible and/or the outer surface of the thermal insulation structure side portion;

The first central axis has a first angle with the outer surface of the side wall of the crucible, the first central axis has a second angle with the inner surface of the thermal insulation structure side portion, the first angle is < 90°, and the second angle is < 90°.

Optionally, a value of the first angle is 5° to 30°. Further, a range of the value of the first angle has a lower limit selected from 7°, 10°, 13° or 15°, and an upper limit selected from 28°, 25°, 23°, 20° or 18°.

Optionally, a value of the second angle is 5° to 30°. Further, a range of the value of the second angle has a lower limit selected from 7°, 10°, 13° or 15°, and an upper limit selected from 28°, 25°, 23°, 20° or 18°.

Preferably, the first angle and the second angle are substantially equal.

Optionally, there is a first distance from an opening face of the crucible to an inner surface of the thermal insulation structure top portion above it, and the first distance increases along a direction from a center of the crucible to an edge of the crucible.

Optionally, a range of a change value of the first distance is 5 mm to 50 mm. Optionally, the range of the change value of the first distance has a lower limit selected from 10 mm, 15 mm, 20 mm, 25 mm or 30 mm, and an upper limit selected from 15 mm, 20 mm, 25 mm, 30 mm, 35 mm, 40 mm or 45 mm.

Optionally, an outer surface of the thermal insulation structure is a cylinder, the thermal insulation structure top portion has no opening; an inner surface of the thermal insulation structure bottom portion is substantially cylindrical; along the direction from the bottom to the opening of the crucible, the inner surface of the thermal insulation structure side portion extends in a direction away from the central axis of the crucible; and the thermal insulation structure top portion is thickened along a direction from the edge to the center of the crucible;

The inner surface of the side wall of the crucible is substantially cylindrical, and an outer wall of the crucible has substantially a same extension direction as the inner surface of the thermal insulation structure side portion.

Optionally, the seed crystal unit is provided at the opening of the crucible, and the seed crystal unit includes a seed crystal of the silicon carbide single crystal.

Optionally, the thermal insulation structure has no opening structure.

According to another aspect of the present application, there is provided a large-sized high-purity silicon carbide single crystal, prepared by using the above-described method.

According to still another aspect of the present application, there is provided a preparation method of a large-sized high-purity silicon carbide single crystal substrate, the method comprising the preparation method of the large-sized high-purity silicon carbide single crystal according to any one of the above, and step 4): substrate preparation stage: cutting, grinding and polishing the high-purity silicon carbide single crystal obtained, to prepare the high-purity semi-insulating silicon carbide single crystal substrate.

According to a further aspect of the present application, there is provided a large-sized high-purity silicon carbide single crystal substrate, prepared by using the above-described method.

Preferably, the method is used for preparing a semi-insulating silicon carbide single crystal having a diameter of 4 to 12 inches and a substrate thereof. Further, the method is used for preparing a semi-insulating silicon carbide single crystal having a diameter greater than 8 inches and less than or equal to 12 inches and a substrate thereof.

In the present application, the "large-sized" as described in the large-sized high-purity silicon carbide single crystal and the large-sized silicon carbide single crystal substrate refers to a diameter of 4 to 12 inches.

In the present application, the PVT method refers to a physical vapor transport method.

In the prior art, crystal growth is performed by using the PVT method, in which a crystal growth thermal field is created by heating of the crucible wall and then transmitted to the interior of the crucible. The further away from the outer wall of the crucible, the lower the temperature, resulting in a relatively large radial temperature gradient inside the crucible. This situation is even more serious as the sizes of the crucible and the crystal increase. A resistivity of the high-purity semi-insulating silicon carbide single crystal substrate is determined by a concentration of electroactive impurities in the crystal, wherein, nitrogen, a shallow-energy-level donor element, plays a decisive role in a value and distribution of the resistivity. Due to thermal field distribution characteristics when the silicon carbide single crystal is prepared by using the PVT method, a nitrogen concentration from a center to an edge of the crystal gradually decreases, which easily forms a trend that the resistivity increases from the center to the edge in the radial direction, causing uneven resistivity distribution on a same substrate.

Advantageous effects of the present application include, but are not limited to that:

The thermal field structure for growing the silicon carbide single crystal according to the present application, by redesigning the crucible and the thermal insulation structure coated on the periphery of the crucible, has a uniform thermal field structure formed in a radial direction, so as to improve radial uniformity of quality of the silicon carbide single crystal, and make it possible to prepare the high-quality large-sized high-purity semi-insulating silicon carbide single crystal substrate.

By using the preparation method of the silicon carbide single crystal according to the present application, the high-quality large-sized high-purity semi-insulating single crystal and single crystal substrate can be prepared; and in the preparation method according to the present application, an axial temperature gradient is created by using different wall thicknesses of the crucible and different thicknesses of the thermal insulation structure, and by changing a thermal insulation structure on the upper side of the graphite crucible at a same time, so as to create a thermal field structure with a uniform radial temperature distribution, which allows the internal thermal field of the large-sized crucible to be uniformly distributed in the radial direction.

In the present application, by changing the thermal field distribution of the PVT method, and changing the conventional method for creating the axial temperature gradient through heat dissipation with the upper thermal insulation hole, into creating the axial temperature gradient by using different wall thicknesses of the crucible and different thicknesses of the thermal insulation structure, and changing a thermal insulation structure on the upper side of the graphite crucible at a same time, a thermal field structure with a uniform radial temperature distribution is created. Since the nitrogen element grows into the crystal along with the temperature gradient, such a thermal field structure with a uniform radial temperature distribution will direct the nitrogen element to be uniformly distributed in the radial direction. The high-purity semi-insulating silicon carbide single crystal and single crystal substrate with a uniform radial resistivity and a low stress are prepared by using the method.

### BRIEF DESCRIPTION OF THE DRAWINGS

The drawings illustrated here are provided for further understanding the embodiments of the present application and constitute a part of the present application, and are used for explaining the present application together with the exemplary embodiments of the present application and description thereof, rather than improperly limiting the present application. In the drawings:
FIG. 1 is a schematic diagram of a thermal field structure including a crucible according to an embodiment of the present application.
FIG. 2 is a distribution diagram of a resistivity of a high-purity silicon carbide single crystal substrate according to an embodiment of the present application.

### DETAILED DESCRIPTION

In order to explain the overall concept of the present application more clearly, detailed description is provided below by way of examples in conjunction with the accompanying drawings.

In order to understand the above objectives, features and advantages of the present application more clearly, hereinafter, the present application will be further described in detail in conjunction with the accompanying drawings and specific implementation modes. It should be noted that, in case of no conflict, the embodiments of the present application and the features in the embodiments may be combined with each other.

In the following description, numerous specific details are set forth in order to facilitate full understanding of the present application; however, the present application may also be implemented in other different ways than those described herein. Therefore, the scope of the present application is not limited by the specific embodiments disclosed below.

In addition, in the description of the present application, it should be understood that directional or positional relationships shown by terms such as "upper", "lower", "front", "rear", "left", "right", "inner", "outer", "axial", "radial" and "circumferential" are directional or positional relationships shown as in the drawings, which only means to facilitate description of the present application and simplify the description, but do not indicate or imply that the devices or components must have specific directions, or be constructed or operated in the specific directions, and are not limitative of the present application.

Moreover, terms like "first" and "second" are merely provided for the purpose of description other than indicating or implying their relative importance or implicitly denoting the number of technical features indicated thereby. Thus, features with "first" or "second" defined may include one or more of the features either explicitly or implicitly. In the description of the present application, the term "a plurality of' refers to two or more, unless otherwise unambiguously and specifically defined.

In the present application, unless otherwise unambiguously specified and defined, terms like "installing", "coupling", "connection" and "fixing" should be construed in its broad sense, for example, it may be fixed connection, or detachable connection, or integral connection; it may also be mechanical connection, or electrical connection, or communication; it may also be direct connection, or may also be indirect connection through an intermediate medium; or it may also be intercommunication of two components or interaction of two components. It will be understood by those ordinarily skilled in the art that the specific meanings of the above terms vary in different contexts.

In the present application, unless otherwise unambiguously specified and defined, the first feature being "above" or "below" the second feature may be direct contact between the first feature and the second feature, or indirect contact between the first feature and the second feature through an intermediate medium. In the description of the present specification, description with reference to the terms such as "one embodiment", "some embodiments", "an example", "a specific example", or "some examples" means that a specific feature, a structure, a material or a characteristic described in conjunction with the embodiment or example is included in at least one embodiment or example of the present application. In the present specification, schematic representation of the above-described terms is not necessarily addressed with respect to a same embodiment or example. Furthermore, specific features, structures, materials or characteristics described may be combined in a suitable manner in any one or more embodiments or examples.

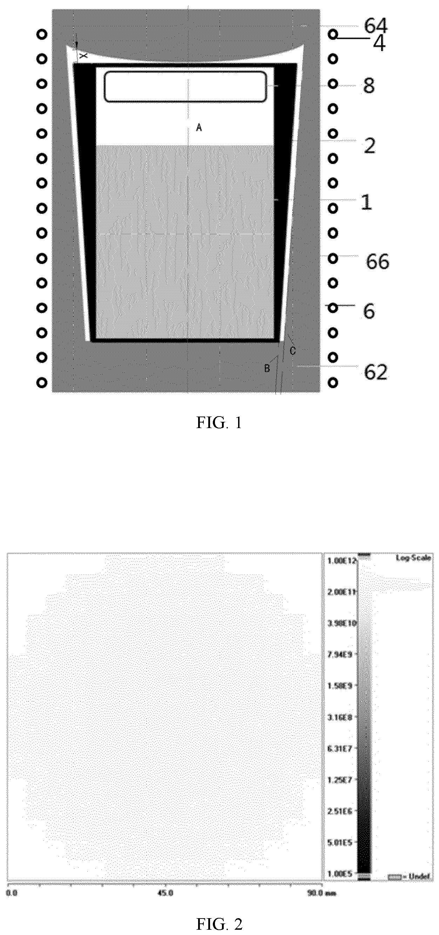

Referring to FIG. 1, an embodiment of the present application discloses a thermal field structure including a crucible that is used in silicon carbide single crystal growth, the thermal field structure including a crucible 2, a heating unit and a thermal insulation structure 6. The crucible 2 is located inside the sealed thermal insulation structure 6, the heating unit heats an outer wall of the crucible 2 by induction, and the heating unit is provided on the periphery of the thermal insulation structure 6. A raw material 1 for growing the crystal is placed in the crucible 2.

An embodiment of the present application discloses a device for growing a silicon carbide single crystal, the device comprising a thermal field structure including a crucible and a seed crystal unit 8, the thermal field structure including a crucible 2, a heating unit and a thermal insulation structure 6. The device comprises a graphite crucible 2, a heating unit, a thermal insulation structure 6 and a seed crystal unit 8. The graphite crucible 2 is located inside the sealed thermal insulation structure 6, the heating unit heats an outer wall of the graphite crucible 2 by induction, and the heating unit is provided on the periphery of the thermal insulation structure 6. A raw material 1 for growing the crystal is placed in the graphite crucible 2. An inner wall of the graphite crucible 2 is substantially cylindrical, and a side wall of the graphite crucible 2 is linearly thickened along a direction from a bottom to an opening of the graphite crucible 2.

The heating unit only needs to heat the outer wall of the crucible 2, the heating unit is composed of a power controller and a corresponding medium-frequency induction coil 4; the induction coil 4 is located on the periphery of a side portion of the thermal insulation structure 6, surrounding the thermal insulation structure 6 and sharing a first central axis with the crucible 2. The medium-frequency induction coil heats the crucible 2 by induction.

The crucible 2 may be a graphite crucible, but is not limited to a graphite crucible, and may be made of any material used for preparing the silicon carbide single crystal. The inner wall of the graphite crucible 2 is substantially cylindrical, and the side wall of the graphite crucible 2 is linearly thickened along the direction from the bottom to the opening of the graphite crucible 2.

The thermal insulation structure 6 is made of a material with a thermal insulation property, e.g., made of graphite thermal insulation felt; the thermal insulation structure 6 includes a thermal insulation structure side portion 66, a thermal insulation structure bottom portion 62 and a thermal insulation structure top portion 64.

Further, the thermal field structure has a seed crystal unit 8 therein, the seed crystal unit 8 is provided inside a cover body of the graphite crucible 2, and the thermal insulation structure 6 has no opening structure. The seed crystal unit 8 includes a seed crystal of the silicon carbide single crystal.

The crucible 2 and the thermal insulation structure 6 share a first central axis A, the first central axis A is parallel to an inner surface of the side wall of the crucible 2 and an outer surface of a wall portion of the thermal insulation structure 6; the first central axis A has a first angle with an outer surface of the side wall of the crucible 2, i.e., a schematic line B in the diagram; the first central axis A has a second angle with an inner surface of the wall portion of the thermal insulation structure 6, i.e., a schematic line C in the diagram; and the first angle and the second angle are < 90°.

As an implementation mode of the present application, according to a skin effect of heating the graphite crucible 2 at a medium frequency, when the graphite crucible 2 is heated at a medium frequency, the outer wall of the graphite crucible 2 is a heat source. In this embodiment, the outer wall of the graphite crucible 2 has a trapezoidal shape, an inner side of the graphite crucible 2 has a straight cylindrical shape, and a wall thickness of the graphite crucible 2 decreases from a position of a seed crystal to the bottom of the graphite crucible 2. The graphite thermal insulation felt 6 on the periphery of the graphite crucible 2 is composed of a thermal insulation felt bottom portion 62, a thermal insulation felt top portion 64 and a thermal insulation felt side portion 66, wherein, the thermal insulation felt bottom portion 62 has a regular cylindrical shape; the thermal insulation felt side portion 66 has a trapezoidal structure along an outer diameter of the graphite crucible 2, that is, a thickness of the thermal insulation felt side portion 66 is the smallest close to an upper portion of the graphite crucible 2 and gradually increases as it approaches the bottom of the graphite crucible 2; a side of the thermal insulation felt top portion 64 that is close to the graphite crucible 2 is dome-shaped; there is a first distance X from an opening face of the graphite crucible 2 to an inner surface of a wall portion of the thermal insulation felt top portion 64 above it, a range of a change value of the first distance X is 5 mm to 50 mm, the thermal insulation felt top portion 64 no longer retains a circular hole for measuring temperature; and further, the change value of the first distance X is 25 mm.

A thickness of the graphite crucible cylinder according to the implementation mode of the present application linearly decreases from top to bottom, wherein, the graphite crucible has the inner wall in a vertical straight line, and the outer wall in a slanted line. As a surface layer of the outer wall of the graphite crucible is heated by induction, heat generated by a thicker graphite wall in the upper portion of the graphite crucible, when transmitted to an inner chamber of the graphite crucible, has an efficiency in the upper portion of the graphite crucible smaller than that in the thinner lower portion of the graphite crucible, so that a higher-temperature region of the lower portion and a lower-temperature region of the upper portion may be formed in the graphite crucible chamber, thus creating an axial temperature gradient. An angle formed between straight lines of section planes of the inner side and the outer side of the graphite crucible wall should be limited to 5° to 30°, that is, the first angle between the outer surface of the graphite crucible and the first central axis is 5° to 30°, and the first angle can balance the temperature gradient created and a heating efficiency of the graphite crucible. Further, the first angle between the outer surface of the graphite crucible and the first central axis is 20°.

Further, the thermal insulation structure outside the graphite crucible according to the implementation mode of the present application is made of graphite felt; an outer portion of the thermal insulation structure, i.e., the graphite felt has a cylindrical structure; an outer surface of a graphite felt side portion is in a vertical straight line, and an inner surface of the graphite felt side portion is parallel to the outer wall of the graphite crucible. An angle between section planes of an inner side and an outer side of the graphite felt is 5° to 30°, that is, a second angle between the inner surface of the graphite felt side portion and the first central axis is 5° to 30°. A thinner region of the graphite crucible lower portion is coated with a thicker portion of the graphite felt to reduce heat loss, so as to further create a high-temperature region; a thinner region of the graphite crucible upper portion is coated with thinner graphite felt which results in more heat loss, so as to form a low-temperature region. Thus, an axial temperature gradient may be further created in the graphite chamber of the graphite crucible.

Further, in the implementation mode of the present application, a face of the graphite felt at an upper side of the graphite crucible that is close to the graphite crucible is curved and the graphite crucible center is no longer provided with an opening. According to the above-described design of the graphite crucible and the thermal insulation felt, an axial temperature gradient can be created in the graphite crucible chamber, to replace the central hole provided in the upper thermal insulation felt for heat dissipation and create an axial temperature ladder. However, as the graphite crucible wall generates heat, there is still a temperature ladder with a higher temperature in a region close to the graphite crucible wall and a lower temperature in a chamber center away from the graphite crucible wall, resulting in a radial temperature gradient. By the curved design, an upper center of the graphite crucible is closer to the upper graphite felt, and an edge of the graphite crucible is farther away from the upper thermal insulation graphite felt, so that the graphite crucible has less heat dissipation in the center and more heat dissipation at the edge, which mutually compensates for the situation of heat generation of the graphite crucible wall, to reduce or even eliminate the radial temperature gradient. A height difference of a curved surface of the upper thermal insulation felt should be kept between 5 mm to 50 mm, which can reasonably control the radial temperature gradient.

A thermal field structure obtained after the graphite thermal insulation felt thermal insulation structure and the graphite crucible are prepared according to the above-described method will form a thermal field structure whose radial temperature gradient is close to zero when preparing the silicon carbide single crystal. The prepared thermal field structure is used in growth of a high-purity silicon carbide single crystal, and the preparation method of the high-purity silicon carbide single crystal comprises steps of:
① Placing a certain amount of silicon carbide powder in the graphite crucible, wherein, purity of the silicon carbide powder should be above 99.9999%, a concentration of shallow-energy-level donor impurities contained therein such as nitrogen is below 1×10¹⁶ cm⁻³, and a sum of concentrations of shallow-energy-level acceptor impurities such as boron and aluminum should be below 1×10¹⁶ cm⁻³;
② Placing the seed crystal for growing the silicon carbide single crystal on an upper portion of the silicon carbide powder inside the graphite crucible, then sealing the graphite crucible; placing the sealed graphite crucible inside the graphite thermal insulation felt thermal insulation structure, transferring the whole system into a single crystal growing apparatus, and then sealing the furnace;
③ Evacuating the furnace so that a pressure therein is 10⁻⁵ Pa, and holding for 5 h to 10 h, to remove residual impurities in the furnace chamber, and then gradually charging a shielding gas such as argon or helium into the furnace chamber;
④ Raising a pressure inside the furnace to 10 mbar to 100 mbar at a rate of 30 mbar/h to 50 mbar/h while increasing a temperature inside the furnace to 2,100°C to 2,200°C at a rate of 10°C/h to 20°C/h, and holding for 50 h to 100 h at the temperature, to complete the growth process of the silicon carbide single crystal; and
⑤ Discontinuing heating the furnace after the growth of the single crystal is completed, and after the furnace temperature is naturally lowered to room temperature, opening the furnace and taking out the graphite crucible, to obtain the high-purity silicon carbide single crystal.

The silicon carbide single crystal is prepared according to the above-described method, to obtain high-purity silicon carbide single crystals 1# to 4#, and differences between specific preparation parameters and those of the above-described method are as shown in Table 1.

**Table 1**

| Sample | First angle | Second angle | First distance/mm | Raw material | Parameters in impurity removal stage | Parameters in crystal growth stage |
|---|---|---|---|---|---|---|
| High-purity silicon carbide single crystal 1# | 20° | 20° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |
| High-purity silicon carbide single crystal 2# | 20° | 20° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 5 h | Raising a pressure inside the crucible to 10 mbar at a rate of 30 mbar/h while increasing a temperature in the crucible to 2,100°C to 2,200°C at a rate of 10°C/h, and holding for 50 h |
| High-purity silicon carbide single crystal 3# | 20° | 20° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 10 h | Raising a pressure inside the crucible to 100 mbar at a rate of 50 mbar/h while increasing a temperature in the crucible to 2,100°C to 2,200°C at a rate of 20°C/h, and holding for 100 h |
| High-purity silicon carbide single crystal 4# | 20° | 20° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 9 h | Raising a pressure inside the crucible to 70 mbar at a rate of 40 mbar/h while increasing a temperature in the crucible to 2,100°C to 2,200°C at a rate of 18°C/h, and holding for 60 h |
| High-purity silicon carbide single crystal 5# | 5° | 5° | 5 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |
| High-purity silicon carbide single crystal 6# | 50° | 50° | 50 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |
| High-purity silicon carbide single crystal D1# | 3° | 3° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |
| High-purity silicon carbide single crystal D2# | 20° | 20° | 55 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |
| High-purity silicon carbide single crystal D3# | 60° | 60° | 25 | A concentration of an N element is 5×10¹⁵ cm⁻³, and a concentration of boron and aluminum elements is 5×10¹⁵ cm⁻³ | Evacuating so that a pressure is 10⁻⁵ Pa, and holding for 8 h | Raising a pressure inside the crucible to 50 mbar at a rate of 40 mbar/h while increasing a temperature in the crucible to 2,100°C to 2,200°C at a rate of 15°C/h, and holding for 80 h |

Silicon carbide single crystal 1#, silicon carbide single crystal 2#, silicon carbide single crystal 3#, silicon carbide single crystal 4#, silicon carbide single crystal 5#, silicon carbide single crystal 6#, silicon carbide single crystal D1#, silicon carbide single crystal D2# and silicon carbide single crystal D3# prepared are respectively subjected to same cutting, grinding and polishing methods, to respectively obtain silicon carbide single crystal substrate 1#, silicon carbide single crystal substrate 2#, silicon carbide single crystal substrate 3#, silicon carbide single crystal substrate 4#, silicon carbide single crystal substrate 5#, silicon carbide single crystal substrate 6#, silicon carbide single crystal substrate D1#, silicon carbide single crystal substrate D2# and silicon carbide single crystal substrate D3#; and silicon carbide single crystal substrate 1#, silicon carbide single crystal substrate 2#, silicon carbide single crystal substrate 3#, silicon carbide single crystal substrate 4#, silicon carbide single crystal substrate 5#, silicon carbide single crystal substrate 6#, silicon carbide single crystal substrate D1#, silicon carbide single crystal substrate D2# and silicon carbide single crystal substrate D3# respectively have specifications of 4 to 12 inches.

Resistivity distributions of silicon carbide single crystal substrate 1#, silicon carbide single crystal substrate 2#, silicon carbide single crystal substrate 3#, silicon carbide single crystal substrate 4#, silicon carbide single crystal substrate 5#, silicon carbide single crystal substrate 6#, silicon carbide single crystal substrate D1#, silicon carbide single crystal substrate D2# and silicon carbide single crystal substrate D3# prepared are respectively tested. Usually, a radial resistivity difference of a semi-insulating silicon carbide single crystal substrate is above one order of magnitude, the resistivity of 4-to-8-inch semi-insulating silicon carbide single crystal substrates 1# to 6# prepared in the embodiment of the present application can reach above 1×10¹⁰ Ω•cm, and resistivity radial distributions are controlled within one order of magnitude, and may be further controlled within 50%, so as to implement uniform resistivity distribution of the silicon carbide single crystal substrates. However, silicon carbide single crystal D1#, silicon carbide single crystal D2# and silicon carbide single crystal D3# have poor uniformity of resistivity distributions, and resistivity radial distributions are greater than two orders of magnitude. The structure tested is illustrated with 4-inch silicon carbide single crystal substrate 1# as an example: a resistivity distribution of silicon carbide single crystal substrate 1# is shown in FIG. 2, and a resistivity of silicon carbide single crystal substrate 1# is uniformly distributed. With respect to the 4-inch semi-insulating silicon carbide single crystal substrate, the resistivity has a maximum value located in an edge region, and a minimum value located in a central region; resistivity values are respectively 4.24×10¹¹ Ω•cm and 4.84×10¹¹ Ω•cm, and a difference between the resistivity values is less than 50%.

Since a radial temperature of the growth interface of the silicon carbide single crystal is kept uniform, impurities and intrinsic point defects are uniformly distributed in the radial direction in the crystal growth process, which may further implement a larger-sized high-purity semi-insulating silicon carbide single crystal substrate with a uniform resistivity distribution in the radial direction.

Bow and Warp of silicon carbide single crystal substrate 1#, silicon carbide single crystal substrate 2#, silicon carbide single crystal substrate 3#, silicon carbide single crystal substrate 4#, silicon carbide single crystal substrate 5#, silicon carbide single crystal substrate 6#, silicon carbide single crystal substrate D1#, silicon carbide single crystal substrate D2# and silicon carbide single crystal substrate D3# prepared are respectively tested. Bow and Warp of 4-to-8-inch silicon carbide single crystal substrates 1# to 6# prepared are within 10 µm. For example, 4-inch silicon carbide single crystal substrate 1# has a Bow value of 3.09 µm and a Warp value of 6.20 µm, so it has excellent surface quality.

The crucible can reduce a radial temperature gradient so that an inner stress of the silicon carbide crystal is also reduced at a same time, so the prepared silicon carbide single crystal substrate has a smaller stress, which is favorable for reducing Bow and Warp, to obtain a higher-quality silicon carbide single crystal substrate. Bow values and Warp values of silicon carbide single crystal D1#, silicon carbide single crystal D2# and silicon carbide single crystal D3# are respectively 23.39 µm/31.74 µm, 19.27 µm/29.73 µm and 27.84 µm/40.66 µm, which are much greater than 10 µm.

The resistivity of 8-to-12-inch semi-insulating silicon carbide single crystal substrates 1# to 6# prepared in the embodiment of the present application can reach above 1×10¹⁰ Ω•cm, and resistivity radial distributions are controlled within one order of magnitude, and may further be controlled within 80%, so as to implement uniform resistivity distributions of the silicon carbide single crystal substrates. Bow values and Warp values of the 8-to-12-inch silicon carbide single crystal substrates can be controlled within 10 µm.

The above are only embodiments of the present application, but the scope of the present application is not limited by these specific embodiments, and is determined by the claims of the present application. Various changes and modifications may be made to the present application by those skilled in the art. Any modification, equivalent substitution, improvement, and the like, made within the technical spirit and principles of the present application should be covered within the protection scope of the present application.

## Claims

1. A device for growing a silicon carbide single crystal, comprising a graphite crucible, a heating unit, a seed crystal unit and a thermal insulation structure, wherein, the thermal insulation structure includes a thermal insulation structure top portion, a thermal insulation structure side portion and a thermal insulation structure bottom portion; an inner wall of the graphite crucible has a substantially cylindrical shape, a side wall of the graphite crucible is linearly thickened along a direction from a bottom to an opening of the graphite crucible.

2. The device for growing the silicon carbide single crystal according to claim 1, wherein, the graphite crucible is located in a sealed cavity of the thermal insulation structure.

3. The device for growing the silicon carbide single crystal according to claim 1, wherein, a wall portion of the thermal insulation structure side portion is linearly thickened along a direction from the opening to the bottom of the graphite crucible.

4. The device for growing the silicon carbide single crystal according to claim 1, wherein, there is a first distance from an opening cross section of the graphite crucible to an inner surface of the thermal insulation structure top portion above it, and the first distance increases along a direction from a center of the graphite crucible to an edge of the graphite crucible.

5. The device for growing the silicon carbide single crystal according to claim 1, wherein, the heating unit heats the graphite crucible by induction.

6. The device for growing the silicon carbide single crystal according to claim 1, wherein, the graphite crucible and the thermal insulation structure share a first central axis;
the first central axis is parallel to an inner surface of the side wall of the graphite crucible and/or an outer surface of the thermal insulation structure side portion; and
the first central axis has a first angle with an outer surface of the side wall of the graphite crucible, the first central axis has a second angle with an inner surface of the thermal insulation structure side portion; and values of the first angle and the second angle are 5° to 30°.

7. The device for growing the silicon carbide single crystal according to claim 4, wherein, a change value of the first distance is 5 mm to 50 mm.

8. The device for growing the silicon carbide single crystal according to claim 1, wherein, an outer surface of the thermal insulation structure is a cylinder, the thermal insulation structure top portion has no opening; an inner surface of the thermal insulation structure bottom portion is substantially cylindrical; along the direction from the bottom to the opening of the graphite crucible, the inner surface of the thermal insulation structure side portion extends in a direction away from the central axis of the graphite crucible; and the thermal insulation structure top portion is thickened along a direction from an edge to a center of the graphite crucible.

9. The device for growing the silicon carbide single crystal according to claim 1, wherein, the inner surface of the side wall of the graphite crucible is substantially cylindrical, and an outer wall of the graphite crucible has substantially a same extension direction as the inner surface of the thermal insulation structure side portion.

10. A crystal growing device, comprising the device for growing the silicon carbide single crystal according to any one of claims 1 to 9.

11. A thermal field structure for growing a silicon carbide single crystal, comprising a crucible, a heating unit, and a thermal insulation structure, wherein, the thermal insulation structure includes a thermal insulation structure top portion, a thermal insulation structure side portion and a thermal insulation structure bottom portion; and the crucible is located in a sealed cavity of the thermal insulation structure; and
the side wall of the crucible has a wall thickness of an opening region greater than a wall thickness of a bottom region.

12. The thermal field structure according to claim 11, wherein, the crucible is a graphite crucible.

13. The thermal field structure according to claim 11, wherein, the side wall of the crucible is linearly thickened along a direction from a bottom to an opening of the crucible.

14. The thermal field structure according to claim 13, wherein, a wall portion of the thermal insulation structure side portion is linearly thickened along a direction from the opening to the bottom of the crucible.

15. The thermal field structure according to claim 11, wherein, there is a first distance from an opening cross section of the crucible to an inner surface of the thermal insulation structure top portion above it, and the first distance increases along a direction from a center of the crucible to an edge of the crucible.

16. The thermal field structure according to claim 15, wherein, a change value of the first distance is 5 mm to 50 mm.

17. The thermal field structure according to claim 11, wherein, the crucible and the thermal insulation structure substantially share a first central axis;
the first central axis is substantially parallel to an inner surface of a side wall of the crucible and/or an outer surface of the thermal insulation structure side portion; and
the first central axis has a first angle with an outer surface of the side wall of the crucible and/or, the first central axis has a second angle with an inner surface of the thermal insulation structure side portion, and the first angle and the second angle are < 90°.

18. The thermal field structure according to claim 11, wherein, the crucible and the thermal insulation structure share a first central axis;
the first central axis is parallel to an inner surface of a side wall of the crucible and/or an outer surface of the thermal insulation structure side portion; and
the first central axis has a first angle with an outer surface of the side wall of the crucible, the first central axis has a second angle with an inner surface of the thermal insulation structure side portion, and the first angle and the second angle are < 90°.

19. The thermal field structure according to claim 17 or 18, wherein, a value of the first angle is 5° to 30°, and a value of the second angle is 5° to 30°.

20. The thermal field structure according to claim 19, wherein, the first angle and the second angle are substantially equal.

21. The thermal field structure according to claim 11, wherein, an outer surface of the thermal insulation structure is a cylinder, the thermal insulation structure top portion has no opening; an inner surface of the thermal insulation structure bottom portion is substantially cylindrical; along a direction from a bottom to an opening of the crucible, an inner surface of the thermal insulation structure side portion extends in a direction away from a central axis of the crucible; and the thermal insulation structure top portion is thickened along a direction from an edge to a center of the crucible; and
an inner surface of a side wall of the crucible is substantially cylindrical, and an outer wall of the crucible has substantially a same extension direction as the inner surface of the thermal insulation structure side portion.

22. A crystal growing device, comprising the thermal field structure according to any one of claims 11 to 21.

23. The crystal growing device according to claim 22, wherein, the crystal growing device is used in preparation of a semi-insulating silicon carbide single crystal having a diameter of 4 to 12 inches.

24. A preparation method of a large-sized high-purity silicon carbide single crystal, wherein, the preparation is performed with the thermal field structure according to any one of claims 11 to 21 or the growing device according to claim 22 or 23.

25. A preparation method of a large-sized high-purity silicon carbide single crystal, comprising steps of:
1) assembly stage: installing a seed crystal unit in a crucible filled with a silicon carbide powder, placing the crucible in a cavity of a sealed thermal insulation structure, and transferring the whole system into a crystal growing device;
2) impurity removal stage: sealing the crystal growing device and evacuating the same, removing impurities and then charging a shielding gas; and
3) crystal growth stage: controlling, by a heating unit of the crystal growing device, a temperature of the crucible for crystal growth, to obtain the high-purity silicon carbide single crystal.

26. The preparation method of the large-sized high-purity silicon carbide single crystal according to claim 25, wherein, purity of the silicon carbide powder is not lower than 99.9999%, and
a concentration of shallow-energy-level donor impurities in the silicon carbide powder is not higher than 1×10¹⁶ cm⁻³, and a concentration of shallow-energy-level acceptor impurities is not higher than 1×10¹⁶ cm⁻³.

27. The preparation method of the large-sized high-purity silicon carbide single crystal according to claim 25, wherein, the crystal growth stage includes: raising a pressure inside the crystal growing device to 10 mbar to 100 mbar at a rate of 30 mbar/h to 50 mbar/h while increasing a temperature inside the crystal growing device to 2,100°C to 2,200°C at a rate of 10°C/h to 20°C/h, and holding for 50 h to 100 h.

28. The preparation method of the large-sized high-purity silicon carbide single crystal according to claim 25, wherein, the crucible and the thermal insulation structure are such that the crucible has an axial temperature gradient therein, and/or a radial temperature is uniform; preferably, the crucible is a graphite crucible.

29. The preparation method of the large-sized high-purity silicon carbide single crystal according to claim 25, wherein, a side wall of the crucible is linearly thickened along a direction from a bottom to an opening of the crucible;
preferably, the thermal insulation structure includes a thermal insulation structure top portion, a thermal insulation structure side portion and a thermal insulation structure bottom portion; and a wall portion of the thermal insulation structure side portion is linearly thickened along a direction from the opening to the bottom of the crucible.

30. The preparation method of the large-sized high-purity silicon carbide single crystal according to claim 29, wherein, the crucible and the thermal insulation structure substantially share a first central axis;
the first central axis is substantially parallel to an inner surface of the side wall of the crucible and/or an outer surface of the thermal insulation structure side portion;
the first central axis has a first angle with an outer surface of the side wall of the crucible and/or, the first central axis has a second angle with an inner surface of the thermal insulation structure side portion;
the first angle is < 90°; preferably, the first angle is 5° to 30°;
the second angle is < 90°; preferably, the second angle is 5° to 30°; and
more preferably, the first angle and the second angle are substantially equal.

31. The preparation method of the large-sized high-purity silicon carbide single crystal according to claim 29, wherein, there is a first distance from an opening face of the crucible to an inner surface of the thermal insulation structure top portion above it, and the first distance increases along a direction from a center of the crucible to an edge of the crucible; and
a range of a change value of the first distance is 5 mm to 50 mm.

32. The preparation method of the large-sized high-purity silicon carbide single crystal according to claim 29, wherein, an outer surface of the thermal insulation structure is a cylinder, the thermal insulation structure top portion has no opening; an inner surface of the thermal insulation structure bottom portion is substantially cylindrical; along the direction from the bottom to the opening of the crucible, the inner surface of the thermal insulation structure side portion extends in a direction away from the central axis of the crucible; and the thermal insulation structure top portion is thickened along a direction from an edge to a center of the crucible; and
an inner surface of the side wall of the crucible is substantially cylindrical, and an outer wall of the crucible has substantially a same extension direction as the inner surface of the thermal insulation structure side portion.

33. A large-sized high-purity silicon carbide single crystal, prepared by using the method according to any one of claims 25 to 32.

34. A preparation method of a large-sized high-purity silicon carbide single crystal substrate, comprising the preparation method of the large-sized high-purity silicon carbide single crystal according to any one of claims 25 to 32, and step 4): substrate preparation stage: cutting, grinding and polishing the high-purity silicon carbide single crystal obtained, to prepare the high-purity semi-insulating silicon carbide single crystal substrate.

35. A large-sized high-purity silicon carbide single crystal substrate, prepared by using the method according to claim 34.
